(19) Europäisches Patentamt
European Patent Office
Office européen des brevets

(11) **EP 3 109 899 B1**

(12) **FASCICULE DE BREVET EUROPEEN**

(45) Date de publication et mention de la délivrance du brevet:
**25.03.2020 Bulletin 2020/13**

(21) Numéro de dépôt: **16175880.0**

(22) Date de dépôt: **23.06.2016**

(51) Int Cl.:
*H01L 23/498* (2006.01)       *H01L 25/10* (2006.01)
*H05K 1/14* (2006.01)        *H01L 23/66* (2006.01)
*H01L 23/538* (2006.01)       *H01L 23/00* (2006.01)
*H01L 23/48* (2006.01)        *H05K 1/18* (2006.01)

(54) **MODULE ELECTRONIQUE 3D COMPORTANT UN EMPILEMENT DE BOITIERS A BILLES**

ELEKTRONISCHES 3D-MODUL, DAS EINEN BGA-STAPEL UMFASST

3D ELECTRONIC MODULE COMPRISING A STACK OF BALL GRID ARRAYS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2015 FR 1555857**

(43) Date de publication de la demande:
**28.12.2016 Bulletin 2016/52**

(73) Titulaire: **3D Plus**
**78530 Buc (FR)**

(72) Inventeur: **VAL, Christian**
**78470 SAINT REMY-LES-CHEVREUSE (FR)**

(74) Mandataire: **Henriot, Marie-Pierre**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A2-2005/104324     US-A- 5 224 023**
**US-A1- 2007 211 711**

**Description**

L'arrivée sur le marché de composants fonctionnant à haute fréquence (mémoires, processeurs, ...) fait que l'utilisation de puces non encapsulées (puces nues) pose de nouveaux problèmes de rendement. Le test de puces nues sous pointes devient très délicat au-delà des fréquences d'environ 1 GHz. La conséquence première est qu'en cas d'empilage de ces composants dans un module électronique 3D, certaines puces pourront fonctionner à la fréquence maximale, d'autres non ; il en résulte qu'un module comprenant une pluralité de puces ne pourra pas fonctionner à la fréquence maximale.

Un moyen de contourner cette difficulté est d'utiliser des puces encapsulées c'est-à-dire placées dans un boîtier qui lui, peut être complètement testé. En effet, un boîtier comprend des sorties sous forme de billes de brasure qui sont à des pas supérieurs à celui des plots des puces par exemple :

Pas des plots des puces : 50 à 100 $\mu$m,
Pas des boîtiers à billes encapsulant une puce: de 400 à 800 $\mu$m.

Des sockets de test peuvent donc être utilisés et les boîtiers sont ainsi testables.

En partant de ce constat, il faut alors trouver une technologie d'empilage adaptée à ces boîtiers et pouvant fonctionner à haute fréquence.

Une nouvelle technique d'empilage de ces types de boîtiers est proposée.

Plus précisément l'invention a pour objet un module électronique 3D selon la revendication 1 qui comprend :

- 2 boîtiers électroniques comprenant chacun au moins une puce encapsulée et des billes de sortie sur une seule face du boîtier dite face principale joignant deux faces latérales,
- disposés entre les 2 boîtiers, 2 circuits flexibles mécaniquement liés entre eux disposés entre les 2 boîtiers, chaque circuit flexible étant associé à un boîtier et comportant :

o sur une face des premiers plots d'interconnexion électrique en contact avec les billes du boîtier associé,
o à son extrémité une partie repliée et collée sur une face latérale du boîtier associé,
o des seconds plots d'interconnexion électrique sur la face opposée de cette partie repliée.

Selon une caractéristique de l'invention, les deux circuits flexibles sont mécaniquement et électriquement liés entre eux par un circuit imprimé rigide disposé en sandwich entre les deux circuits flexibles.

Ce circuit rigide peut comporter des composants passifs et/ou actifs éventuellement noyés dans ledit circuit rigide.

De préférence le module 3D comporte un cordon de résine époxy disposé au bord du module entre les deux circuits flexibles le long du pliage des circuits flexibles.

Au moins un des deux boîtiers est aminci jusqu'à faire apparaître une face de la puce ; le boîtier comporte alors avantageusement un radiateur placé sur la face apparente de la puce.

Selon une autre caractéristique de l'invention, au moins un des deux circuits flexibles est replié à son autre extrémité sur une autre face latérale du boîtier opposée à la première face latérale, le circuit flexible comportant des composants passifs et/ou actifs au niveau de cette autre extrémité. On désigne par composant actif, une puce nue ou encapsulée.

Les composants passifs et/ou actifs fonctionnent typiquement à des fréquences supérieures à 1 GHz.

L'invention concerne également un empilement électronique 3D, caractérisé en ce qu'il comporte un empilement de plusieurs modules électroniques 3D tels que décrits, collés entre eux par des faces opposées aux faces principales.

L'invention a aussi pour objet un dispositif électronique 3D comportant un circuit imprimé d'interconnexion et un module électronique 3D ou un empilement tels que décrits, monté sur le circuit imprimé d'interconnexion et en contact électrique avec lui par des billes d'interconnexion électrique en contact avec les seconds plots d'interconnexion électrique des circuits flexibles.

D'autres caractéristiques et avantages de l'invention apparaîtront à la lecture de la description détaillée qui suit, faite à titre d'exemple non limitatif et en référence aux dessins annexés dans lesquels :

la figure 1 représente schématiquement un premier exemple de module électronique 3D selon l'invention,
la figure 2 représente schématiquement en éclaté un exemple d'éléments d'un module électronique 3D selon l'invention : un boîtier et le circuit flexible (ou circuit « flex ») qui lui est associé,
la figure 3 représente schématiquement un deuxième exemple de module électronique 3D selon l'invention, avec boîtiers amincis et munis de radiateurs,
les figures 4 représentent schématiquement un troisième exemple de module électronique 3D avec des composants passifs et/ou actifs :

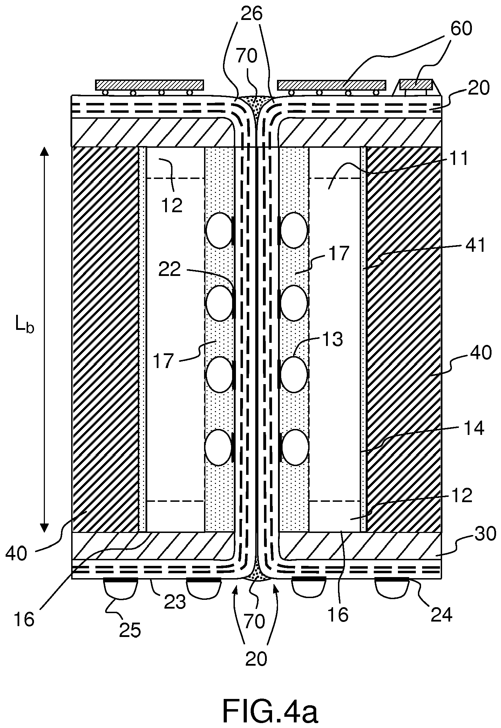

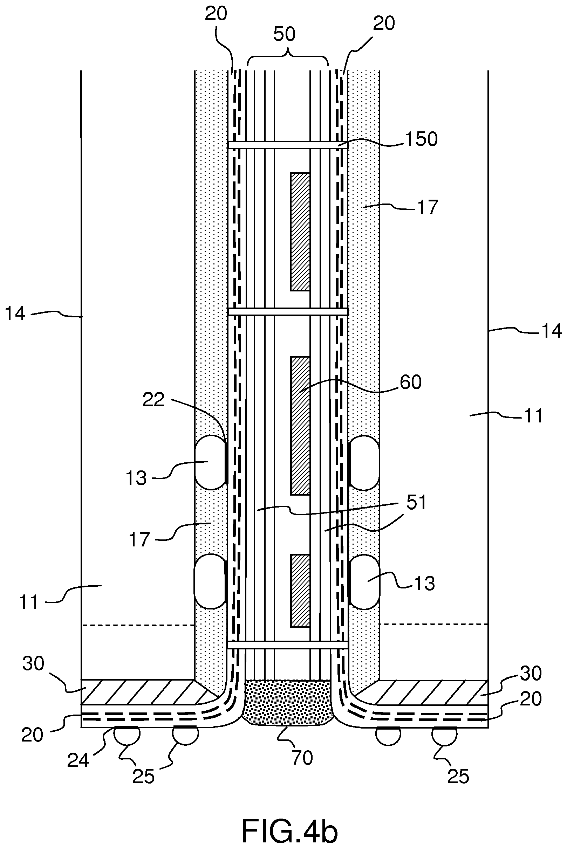

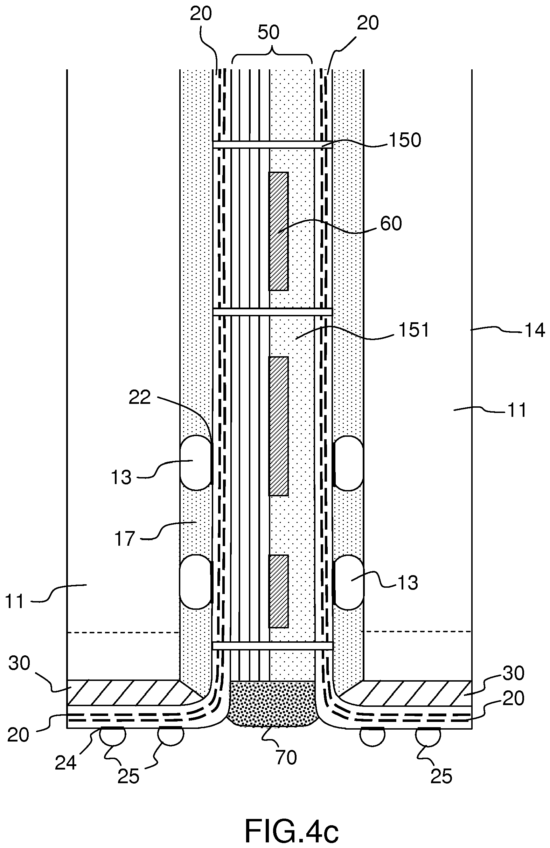

- montés sur les deux circuits flex (fig 4a) ou
- intégrés dans le circuit rigide (ou circuit « core ») (fig 4b) ou
- montés en surface du circuit « core » (fig 4c),

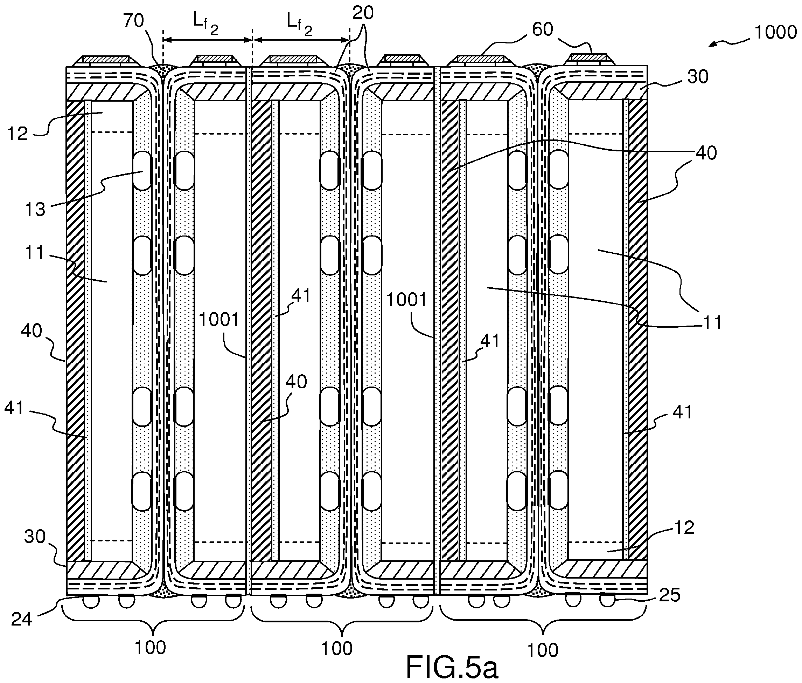

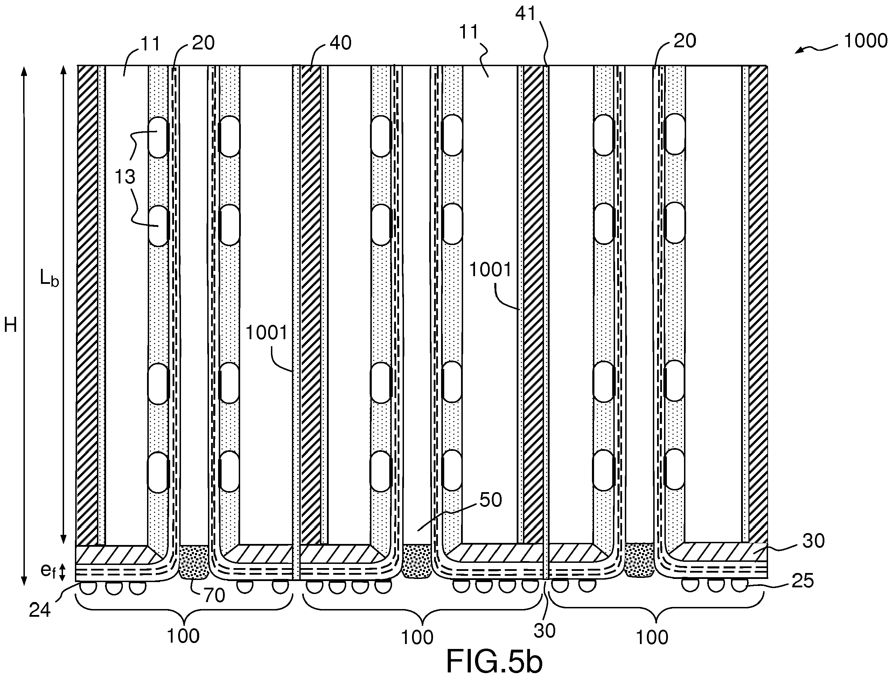

la figure 5 représente schématiquement un exemple d'empilement de modules électroniques 3D avec boîtiers amincis et munis de radiateurs dont certains sont communs à deux modules adjacents, avec composants actifs et/ou passifs montés sur les circuits flex (fig 5a), ou sans (fig 5b).

D'une figure à l'autre, les mêmes éléments sont repérés par les mêmes références.

Dans la suite de la description, les expressions « haut », « bas », avant », « arrière », « côté », sont utilisées en référence à l'orientation des figures décrites. Dans la mesure où le module, l'empilement ou le dispositif peuvent être positionnés selon d'autres orientations, la terminologie directionnelle est indiquée à titre d'illustration et n'est pas limitative.

Des exemples de circuits flexibles sont décrits dans les documents US 2007/0211711, WO 2005/104324 et US 5 224 023.

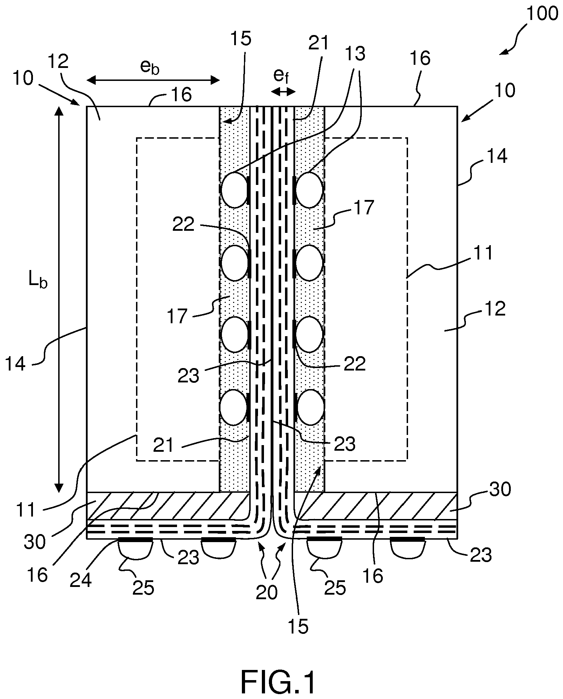

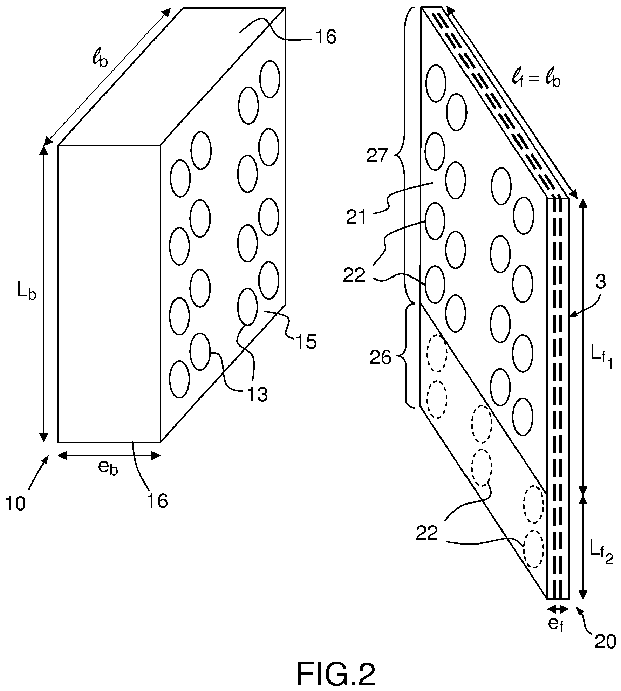

On décrit en relation avec les figures 1 et 2 un premier exemple de module électronique 3D selon l'invention. Deux boîtiers à billes (BGA acronyme de l'expression anglo-saxonne Ball Grid Array) sont reportés sur les 2 faces d'un substrat comportant deux circuits flexibles ou Flex PCB (acronyme de l'expression anglosaxonne Printed Circuit Board) accolés.

Les boîtiers à billes (BGA) 10 comportent chacun au moins une puce 11 encapsulée dans une résine 12 de type époxy ; chaque puce 11 est reliée à des billes de sortie 13 du boîtier disposées sur une seule face du boîtier dite face principale 15. Un boîtier 10 de longueur $L_b$, de largeur $l_b$ et d'épaisseur $e_b$ présente ainsi une face principale 15 et une face opposée désignée face externe 14, toutes deux de dimensions $L_b$ x $l_b$, et des faces latérales 16 de dimensions $l_b$ x $e_b$. On a typiquement les dimensions suivantes :

- 6mm ≤ $L_b$ ≤ 9mm,
- 6mm ≤ $l_b$ ≤ 14mm,
- 0,8mm ≤ $e_b$ ≤ 1,4mm.

Ces boîtiers 10 destinés à être empilés sont électriquement testés par leur fabricant au moyen de sockets de tests et de testeurs appropriés, puis commercialisés en tant que boîtiers testés. Parmi les fabricants de tels boîtiers testés, on peut citer : Micron, Xilinx, Samsung, Freescale, Infineon, St Microelectronics, ... Le module 3D selon l'invention comporte de tels boîtiers testés.

Deux boîtiers testés sont reportés sur les 2 faces d'un substrat appelé PCB en étant face à face. Plus précisément, le PCB est constitué de deux circuits flexibles 20. Chaque circuit flexible 20 de longueur $L_f$ ($L_f=L_{f1}+L_{f2}$), de largeur $l_f$ et d'épaisseur $e_f$, présente également une face principale 21 munie de premiers plots d'interconnexion 22 répartis comme les billes 13 du boîtier, une face opposée 23 de dimensions $L_f$ x $l_f$ et des faces latérales de dimensions $l_f$ x $e_f$. On a :

$$L_f \geq L_b+e_b \text{ et } l_f=l_b.$$

On a typiquement les dimensions suivantes :

- 7mm ≤ $L_f$ ≤ 11mm,
- 6mm ≤ $l_f$ ≤ 14mm,
- 0,8mm ≤ $e_b$ ≤ 1,4mm.

Un circuit Flex 20 qui est généralement multicouche est en général en polyimide c'est-à-dire sans fibre de verre à l'intérieur afin de permettre une déformation importante comme le pliage ; on peut aussi remplacer le polyimide par de la résine époxy non fibrée. Il comporte des pistes électriques destinées à conduire les signaux entre les premiers plots d'interconnexion électrique 22 disposés sur la face principale 21 du flex (et en contact avec les billes de sortie 13 du boîtier) et des seconds plots d'interconnexion électrique 24 situés sur la face opposée 23 d'une partie 26 du circuit flex (destinée à être repliée sur une face latérale du boîtier), de dimension $L_{f2}$ x $l_f$ ; ces seconds plots d'interconnexion 24 qui sur la figure 2 sont sur la face 23 non visible, sont indiqués en pointillé. On a typiquement :

$$L_{f1}=L_b \text{ et } L_{f2} \geq e_b.$$

Chaque boîtier 10 est donc reporté sur un circuit flex 20 de manière à :

- mettre en contact mécanique et électrique (par brasage par exemple en utilisant des brasures habituelles avec ou sans plomb) les billes de sortie 13 du boîtier et les premiers plots d'interconnexion 22 de la partie principale 27 du circuit flex (qui ne sera pas pliée), une partie 26 du circuit flex dépassant donc de la partie principale 27,
- mettre en contact mécanique une face latérale 16 du boîtier avec cette partie 26 du circuit flex (qui dépasse) en pliant celui-ci à 90°, de sorte à présenter les seconds plots d'interconnexion 24 au niveau de ladite face latérale 16 du boîtier.

De la résine chargée 17 (résine époxy par exemple) est insérée de manière classique entre les billes 13.

Ces parties 26 sont collées sur les faces latérales du boîtier. Ce collage est réalisé avec un outillage ou gabarit permettant de maintenir parfaitement plates les parties 26 collées aux faces latérales 16. La colle 30 joue le rôle d'adaptateur de niveau entre les faces latérales 16 du boîtier et les parties 26 flexibles repliées. Ceci est très important pour ce qui concerne le packaging et plus particulièrement les boîtiers BGA qui lors de leur livraison, ont en général un cambrage encore appelé « warpage » qui peut atteindre 50 à 150 μm selon les

dimensions ; ce cambrage nuit donc à la coplanarité des billes 25 et donc au rendement de brasage.

On obtient alors deux paires boîtier-circuit flex, qui sont elles-mêmes assemblées par collage des faces opposées 23 des circuits flex, (colle non représentée sur les figures) pour former finalement un module 3D à deux boîtiers 10 et un PCB comme montré figure 1. Des billes de brasure 25 seront déposées sur les seconds plots d'interconnexion 24 pour permettre de reporter ce module 3D sur le circuit imprimé (ou PCB) de l'utilisateur.

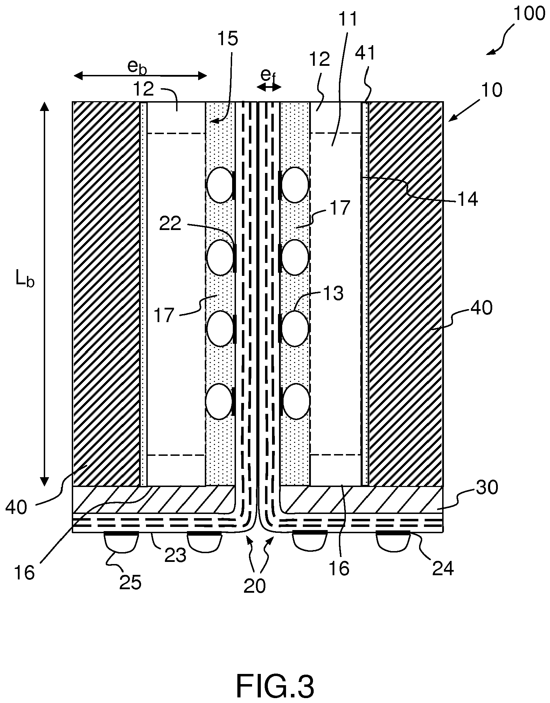

Chaque boîtier 10 peut être aminci comme montré sur la figure 3 : la face arrière de la puce 11 apparait après amincissement. La face externe 14 d'un boîtier aminci peut recevoir un radiateur 40, métallique par exemple, pour évacuer la chaleur générée par les puces 11. Le radiateur 40 est ensuite connecté à une plaque froide au niveau de ses sections. La liaison 41 thermique du radiateur et de la face arrière de la puce 11 s'effectue, en général, soit avec de la colle thermique ou au mieux avec une brasure ; dans ce dernier cas, la face externe 14 est métallisée, par exemple avec un dépôt chimique de nickel et d'or. Dans cette approche, la longueur $L_{f2}$ de la partie 26 du circuit Flex se trouve accrue ce qui peut permettre d'accroître le nombre de seconds plots d'interconnexion 24 ou le pas. Un module 3D peut comporter un radiateur 40 sur chaque boîtier 10 comme montré sur la figure 3 ou un seul radiateur sur un boîtier, qui sera commun à un autre boîtier d'un autre module 3D comme on le verra plus loin dans le cas d'un empilement de modules 3D. Dans ce cas, la longueur $L_{f2}$ diffère d'un circuit flex à l'autre comme on peut le voir pour les modules 100 des figures 5a et 5b.

Comme montré sur les figures 1 à 3, les paires boîtier-circuit flex peuvent être assemblées directement ou, comme montré sur les figures 4 et 5 par l'intermédiaire d'un circuit imprimé rigide central 50 dit circuit « core » de longueur $L_c$, de largeur $l_c$ et d'épaisseur $e_c$, comportant des plans de masse et d'alimentation, mécaniquement et électriquement relié aux parties 27 des deux circuits flex 20 par ses faces de dimensions $L_c \times l_c$. Dit autrement le PCB peut ne comporter que les deux circuits flex 20 ou comporter un circuit « core » 50 entre les deux circuits flex 20. Dans la pratique, le circuit PCB comportant les deux circuits flex 20 avec le circuit « core » 50 entre les deux, est d'abord réalisé avant de reporter chaque boîtier 10 de part et d'autre du circuit PCB puis de plier sur les faces latérales 16 des boîtiers, les parties 26 des deux circuits flex qui dépassent des boîtiers.

La figure 4b présente un exemple de module 3D selon l'invention comprenant dans le PCB entre les deux circuits flex 20, un circuit « core » 50 généralement multicouche intégrant des composants 60 actifs et/ou passifs et notamment des condensateurs de découplage. Sur la figure 4a la couche intégrant des composants 60 est entre deux couches 51 d'un côté et 3 couches 51 de l'autre. Ces condensateurs placés au plus près des puces 11 des boîtiers 10 permettent de délivrer l'énergie avec le minimum d'inductance. Les composants actifs et passifs 60 sont placés dans l'épaisseur du circuit « core » 50 ; les autres niveaux sont ensuite collés sur les composants comme ce qui est fait pour réaliser un PCB. Les trous métallisés 150 traversent tout (comme montré sur la figure) ou partie du « core » et des 2 circuits flex (ou Flex) afin de réaliser les interconnexions.

Selon une alternative que l'on peut voir figure 4c, les composants 60 actifs et/ou passifs, notamment les condensateurs peuvent être montés en surface du circuit « core » 50 qui comporte plusieurs couches 51 ; il s'agit généralement de composants 60 de très petit format (402 pour 1 mm x 0,5 mm) qui permettent de laisser assez d'espace pour passer les trous métallisés qui traverseront le circuit « core » 50. Les composants 60 sont reportés sur le PCB selon les techniques de report en surface, puis un dépôt de résine 151 est effectué sur ces composants 60 afin de disposer d'une surface plane qui recevra la colle permettant de coller le Flex 20 sur celle-ci. L'épaisseur actuelle des condensateurs (e2) est de 0,6 mm et certains fournisseurs proposent déjà des épaisseurs inférieures à 0,4 mm ; l'épaisseur du composant 60 reporté sera donc de 0,7 mm avec une diminution allant vers 0,5 mm pour (e3). Une épaisseur totale (e4) de 1,7 mm à 1,5 mm est tout à fait possible.

La figure 4a représente le module avec des circuits flex 20 pliés sur les 2 faces latérales 16 opposées de chaque boîtier 10. Le principal avantage est dû à la séparation des fonctions :

- Flex pliés sur une face latérale 16 du boîtier (en bas sur la figure) et portant la connectique extérieure (les billes 25).
- Flex pliés sur une face latérale 16 du boîtier opposée à la précédente (en haut sur la figure) avec les composants 60 actifs et/ou passifs (condensateurs, résistances, ...) et/ou circuits actifs du type « buffer » reportés sur leurs faces 23, rendant alors superflu le circuit « core » 50.

Eventuellement, un seul des deux circuits flex 20 comporte des composants 60 sur sa partie repliée vers le haut.

Cette approche avec composants passifs et/ou passifs (intégrés au circuit « core » ou reportés sur lui ou sur les flex) permet de rendre le module 3D électriquement autonome comme peut l'être une barrette DIMM acronyme de l'expression anglo-saxonne Dual In line Memory Module, que ce soit un RDIMM (Registered Dual In line Memory Module) ou un LRDIMM (Low Registered Dual In line Memory Module).

De préférence, lorsque le PCB d'un module 3D 100 comporte un circuit « core » 50 disposé entre les deux circuits flex 20, on introduit un cordon 70 de résine époxy chargée avec de la silice entre les coudes respectivement formés par chaque circuit flex 20 lors du pliage sur la face latérale 16 du boîtier 10 qui lui est associé. Ce cordon 70 qui s'étale donc sur la largeur $l_f$, permet d'éviter d'éventuelles infiltrations de flux lors de l'étape de brasure des billes 25 sur les plots d'interconnexion 24 des circuits « flex ». Dans le cas d'un circuit flex replié sur les deux faces latérales du boîtier, deux cordons 70 seront disposés comme montré sur les figures 4a et 5a.

Plusieurs modules 3D 100 ainsi obtenus peuvent être empilés ; ils sont typiquement collés par une colle ou une résine 1001 de type époxy. On a représenté figures 5 un empilement 1000 de 3 modules 100 comportant donc au total 6 boîtiers 10, mais cela n'est pas limitatif puisque la résistance thermique de chaque boîtier ne dépend plus de l'empilage comme dans le cas des boîtiers superposés ; en effet, chaque boîtier 10 a la même résistance thermique puisqu'il n'est pas influencé par ses voisins.

Sur ces figures les boîtiers 10 sont amincis et munis de radiateurs 40 dont certains sont partagés entre deux boîtiers 10 de modules 100 adjacents notamment pour ne pas augmenter l'épaisseur finale de l'empilement 1000. Sur la figure 5a, les circuits flex 20 sont pliés sur chaque face latérale 16 de boîtier avec la connectique (les billes 25) d'un côté, et les composants 60 passifs et/ou actifs de l'autre ; les circuits « core » 50 sont donc superflus. Sur la figure 5b, les circuits flex 20 sont pliés sur une seule face latérale 16 de boîtier avec la connectique (les billes 25), et les composants passifs et/ou actifs sont intégrés aux circuits « core » 50. Mais n'importe quel module 3D précédemment décrit peut être empilé et collé l'un à l'autre par une colle thermique ou une brasure ; un module 3D à boîtier aminci sans composants passifs vis-à-vis d'une face latérale 16 peut être empilé sur un module 3D à boîtier non aminci avec composants passifs, etc. Cet empilement 1000 est bien sûr destiné à être mécaniquement et électriquement connecté au circuit d'interconnexion de l'utilisateur (non représenté), par les seconds plots d'interconnexion 24 de chaque circuit flex et les billes de brasure 25 déposées sur ces plots.

Les avantages principaux de cette technologie d'empilage 3D par rapport à toutes les autres connues actuellement, sont nombreux :

- Pas de routage sur les faces latérales du module,
- Pas de trous « TPV » (acronyme de l'expression anglo-saxonne Through Polymer Vias) ou « TMV » (acronyme de l'expression anglo-saxonne Through Molded Vias) pour l'interconnexion inter niveau,
- Co-planarité des billes par construction car collage sous gabarit,
- Quasiment pas de limitation sur le nombre de boîtiers à empiler,
- Possibilité d'intégrer le découplage capacitif dans le PCB d'interconnexion de l'utilisateur :

    o pas de moulage,
    ◦ pas de métallisation des faces du module,
    ◦ pas de gravure par laser.

Un inconvénient pourrait être la hauteur H du module 3D qui est dépendante de la longueur $L_b$ des boîtiers BGA standards qui oscille entre 6 et 9 mm, à laquelle il convient d'ajouter l'épaisseur $e_f$ du flex plié et celle des billes soit environ 700 à 800 $\mu$m pour un pliage sur un seul côté.

Ce procédé d'empilage est particulièrement intéressant pour l'empilage de boîtiers de mémoires.

# Revendications

1. Module électronique 3D (100) qui comprend :

    - 2 boîtiers électroniques (10) comprenant chacun au moins une puce encapsulée (11) et des billes de sortie (13) sur une seule face du boîtier dite face principale (15) joignant deux faces latérales (16),
    - 2 circuits flexibles, chacun ayant une première et une deuxième partie
    - disposée entre la face principale de chacun des 2 boîtiers, la première partie de chacun des 2 circuits flexibles (20), lesdites premières parties étant mécaniquement liées entre elles, chaque circuit flexible (20) étant associé à un boîtier (10) et comportant :

        ◦ sur une face (21) des premiers plots d'interconnexion électrique (22) en contact avec les billes de sortie (13) du boîtier associé,
        ◦ à son extrémité la deuxième partie repliée (26) et collée sur une face latérale (16) du boîtier associé,
        ◦ des seconds plots d'interconnexion électrique (24) sur la face de cette partie repliée (26) opposée à la face qui est collée sur ladite une face latérale (16) du boîtier associé.

2. Module électronique 3D selon la revendication précédente, dans lequel les deux circuits flexibles (20) sont mécaniquement et électriquement liés entre eux par un circuit imprimé rigide (50) disposé entre les deux circuits flexibles.

3. Module électronique 3D selon la revendication précédente, dans lequel le circuit imprimé rigide (50) comporte des composants (60) passifs et/ou actifs.

4. Module électronique 3D selon l'une des revendications précédentes, qui comporte un cordon (70) de résine époxy disposé au bord entre les deux circuits flexibles (20) le long du pliage des circuits flexibles.

5. Module électronique 3D selon l'une des revendications précédentes, dans lequel au moins un boîtier (10) est aminci jusqu'à faire apparaître une face de la puce (11) et qui comporte un radiateur (40) placé sur ladite face de la puce.

6.  Module électronique 3D selon l'une des revendications précédentes, dans lequel au moins un circuit flexible (20) est replié à son autre extrémité sur une face latérale (16) du boîtier opposée à la première face latérale, le circuit flexible comportant des composants (60) passifs et/ou actifs au niveau de cette autre extrémité.

7.  Module électronique 3D selon l'une des revendications précédentes, qui comporte des composants (60) passifs et/ou actifs fonctionnant à des fréquences supérieures à 1 GHz.

8.  Empilement électronique 3D (1000), qui comporte un empilement de plusieurs modules électroniques 3D (100) selon l'une des revendications précédentes, collés entre eux par des faces (14) opposées aux faces principales (15).

9.  Dispositif électronique 3D comportant un circuit imprimé d'interconnexion et un module électronique 3D (100) selon l'une des revendications 1 à 7 ou un empilement (1000) selon la revendication 8, monté sur un circuit imprimé d'interconnexion et en contact électrique avec le circuit d'interconnexion par des billes d'interconnexion (25) en contact avec les seconds plots d'interconnexion (24) des circuits flexibles.

**Patentansprüche**

1.  Elektronisches 3D-Modul (100), Folgendes beinhaltend:

    - 2 elektronische Geräte (10), welche jeweils mindestens einen verkapselten Chip (11) und Ausgangskugeln (13) an einer einzigen Seite des Gerätes, genannt Hauptseite (15), beinhaltet, welche die beiden Seitenflächen (16) verbindet,
    - 2 flexible Schaltkreise, welche jeweils einen ersten und einen zweiten Abschnitt aufweisen,
    - wobei zwischen der Hauptseite eines jeden der 2 Geräte der erste Abschnitt eines jeden der 2 flexiblen Schaltkreise (20) angeordnet ist, wobei die ersten Abschnitte mechanisch miteinander verbunden sind, wobei jeder flexible Schaltkreis (20) einem Gerät (10) zugeordnet ist und Folgendes beinhaltet:

        ◦ an einer Seite (21), erste elektrische Verbindungshöcker (22) in Kontakt mit den Ausgangkugeln (13) des zugeordneten Gerätes,

        ◦ an seinem Ende, den zweiten, gekrümmten Abschnitt (26), welcher an einer Seitenfläche (16) des zugeordneten Gerätes aufgeklebt ist,
        ◦ zweite elektrische Verbindungshöcker (24) an der Seite dieses gekrümmten Abschnittes (26), welche derjenigen Seite gegenüber liegt, welche an der Seitenfläche (16) des zugeordneten Gerätes aufgeklebt ist.

2.  Elektronisches 3D-Modul nach dem vorhergehenden Anspruch, bei welchem die beiden flexiblen Schaltkreise (20) mechanisch und elektrisch miteinander über ein starre Leiterplatte (50) verbunden sind, welche zwischen den beiden flexiblen Schaltkreisen angeordnet ist.

3.  Elektronisches 3D-Modul nach dem vorhergehenden Anspruch, bei welchem die starre Leiterplatte (50) passive und/oder aktive Bauteile (60) beinhaltet.

4.  Elektronisches 3D-Modul nach einem der vorhergehenden Ansprüche, beinhaltend einen Strang (70) aus Epoxidharz, welche am Rand zwischen den beiden flexiblen Schaltkreisen (20) entlang der Faltung der flexiblen Schaltkreise angeordnet ist.

5.  Elektronisches 3D-Modul nach einem der vorhergehenden Ansprüche, bei welchem mindestens ein Gerät (10) verschmälert wird, bis eine Seite des Chips (11) bloßgelegt ist und welche einen auf der Seite des Chips platzierten Strahler beinhaltet.

6.  Elektronisches 3D-Modul nach einem der vorhergehenden Ansprüche, bei welchem mindestens ein flexibler Schaltkreis (20) an seinem anderen Ende auf eine Seitenfläche (16) desjenigen Gerätes umgebogen ist, welche der ersten Seitenfläche gegenüber liegt, wobei der flexible Schaltkreis passive und/oder aktive Bauteile (60) auf Höhe dieses anderen Endes beinhaltet.

7.  Elektronisches 3D-Modul nach einem der vorhergehenden Ansprüche, beinhaltend passive und/oder aktive Bauteile (60), welche bei Frequenzen über 1 GHz arbeiten.

8.  Elektronischer 3D-Stapel (1000), beinhaltend einen Stapel mehrerer elektronischer 3D-Module (100) nach einem der vorhergehenden Ansprüche, welche miteinander durch den Hauptseiten (15) gegenüberliegende Seiten (14) verklebt sind.

9.  Elektronische 3D-Vorrichtung, beinhaltend eine Verbindungsleiterkarte und ein elektronisches 3D-Modul (100) nach einem der Ansprüche 1 bis 7 oder einen Stapel (1000) nach Anspruch 8, welches/welcher auf einer Verbindungsleiterkarte montiert ist und in elektrischem Kontakt mit dem Verbindungsschaltkreis durch Verbindungskugeln (25) steht, welche in Kontakt mit den zweiten Anschlusshöckern (24) der flexiblen Schaltkreise stehen.

**Claims**

1. 3D electronic module (100) comprising:

   - two electronic packages (10), each comprising at least one encapsulated chip (11) and output balls (13) on a single face of the package, referred to as the main face (15), joining two lateral faces (16),
   - two flexible circuits, each having a first and a second portion
   - positioned between the main face of each of the two packages, the first portion of each of the two flexible circuits (20), said first and second portions being mechanically connected to one another, each flexible circuit (20) being associated with a package (10) and comprising:

     ∘ on one face (21), first electrical interconnect pads (22) in contact with the output balls (13) of the associated package;
     ∘ at its end, the second portion (26) that is folded over and bonded to a lateral face (16) of the associated package;
     ∘ second electrical interconnect pads (24) on the face of this folded portion (26) opposite the face which is bonded to said lateral face (16) of the associated package.

2. 3D electronic module according to the preceding claim, wherein the two flexible circuits (20) are mechanically and electrically connected to one another by a rigid printed circuit board (50) that is positioned between the two flexible circuits.

3. 3D electronic module according to the preceding claim, wherein the rigid printed circuit board (50) comprises passive and/or active components (60).

4. 3D electronic module according to one of the preceding claims, which comprises a bead (70) of epoxy resin that is positioned on the border between the two flexible circuits (20) along the fold of the flexible circuits.

5. 3D electronic module according to one of the preceding claims, wherein at least one package (10) is thinned until a face of the chip (11) becomes visible and comprises a radiator (40) placed on said face of the chip.

6. 3D electronic module according to one of the preceding claims, wherein at least one flexible circuit (20) is folded, at its other end, over a lateral face (16) of the package opposite the first lateral face, the flexible circuit comprising passive and/or active components (60) at this other end.

7. 3D electronic module according to one of the preceding claims, which comprises passive and/or active components (60) operating at frequencies that are higher than 1 GHz.

8. 3D electronic stack (1000), which comprises a stack of multiple 3D electronic modules (100) according to one of the preceding claims, which modules are bonded to one another by faces (14) opposite the main faces (15).

9. 3D electronic device comprising an interconnect printed circuit board and a 3D electronic module (100) according to one of claims 1 to 7 or a stack (1000) according to claim 8, mounted on an interconnect printed circuit board and electrically connected to the interconnect circuit via interconnect balls (25) that make contact with the second interconnect pads (24) of the flexible circuits.

FIG.1

FIG.2

FIG.3

FIG.4a

FIG.4b

FIG.4c

FIG.5a

EP 3 109 899 B1

FIG.5b

EP 3 109 899 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070211711 A
- WO 2005104324 A
- US 5224023 A